(19) Europäisches Patentamt European Patent Office Office européen des brevets

(11) **EP 3 518 298 A1**

(12) **EUROPEAN PATENT APPLICATION**
published in accordance with Art. 153(4) EPC

(43) Date of publication:
**31.07.2019 Bulletin 2019/31**

(21) Application number: **16916512.3**

(22) Date of filing: **23.09.2016**

(51) Int Cl.:
*H01L 33/48* (2010.01)       *H01L 33/62* (2010.01)
*F21S 2/00* (2016.01)

(86) International application number:
**PCT/CN2016/099797**

(87) International publication number:
**WO 2018/053773 (29.03.2018 Gazette 2018/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Shenzhen Keweitian Eco-Lighting Co., Ltd.**
**Shenzhen, Guangdong 518000 (CN)**

(72) Inventors:
• **XIE, Rui**
  **Xiao Gan**
  **Hubei 432000 (CN)**

• **LIN, Liling**
  **Dong Guan**
  **Guangdong 523000 (CN)**
• **LIU, Gangcheng**
  **Huainan**
  **Anhui 232001 (CN)**

(74) Representative: **Angerhausen, Christoph**
**Boehmert & Boehmert**
**Anwaltspartnerschaft mbB**
**Pettenkoferstrasse 22**
**80336 München (DE)**

(54) **SUN-LIKE SPECTRUM LED LAMP BEAD STRUCTURE**

(57)    Provided is a sun-like spectrum LED lamp bead structure, comprising a first polarity electrode (10), a plurality of LED chips (20) and a circuit board (40). The first polarity electrode (10) cooperates with the circuit board (40) for encapsulating the plurality of LED chips (20). The structure of the first polarity electrode (10) is a three-dimensional structure including a plurality of planes, which can arbitrarily simulate solar spectrum and can maximize the energy-saving characteristics of LED semiconductors.

FIG. 1

**EP 3 518 298 A1**

## Description

### FIELD OF TECHNOLOGY

The present application relates to the field of LED lighting, and particularly to a sun-like spectrum LED lamp bead structure.

### BACKGROUND

As the fourth generation of lighting source, white-light LED has the advantages of solidification, small volume, low heat generation, low power consumption, long life, fast reaction rate, being environmentally friendly and etc. However, the lighting principle of semiconductor LED determines that a LED chip can only be monochromatic light which cannot be directly used for conventional lighting. Therefore, the existing white-light LED technology usually adopts a white-light LED light source made by exciting the yellow-light phosphor with LED blue-light, and is mainly used in general lighting. Although this white-light LED technology has promoted the application of LED semiconductors in the lighting filed and backlights of electronic products, the health and safety hazards of blue-light to human eyes have been confirmed by the medical community. At the same time, there are some negative reports sometimes that white-light LED lighting harms the health and safety of human eyes in practical applications. In addition, the existing white-light LEDs also encounter various technical bottlenecks due to the phosphors powder used in the production thereof, which hinders the normal development of the white-light LED.

The best reference object for artificial light is undoubtedly the sunlight. It is known that the visible light of the sun is a colorful spectrum naturally composed by the seven color scheme of red, orange, yellow, green, cyan, blue and purple. It is because of the colorfulness and variability of the solar spectrum that the complex and diverse species of the earth have been nurtured, and at the same time, the biological colors are given brilliant and colorful. Therefore, only from the perspective of the humanization that conforms to the laws of natural light, and using the lamp as the carrier to achieve the technical height where solar spectrum is arbitrary and artificially simulated, can the LED semiconductor lighting source be truly utilized and thus beneficial to human.

Therefore, one of the technical problems that need to be solved urgently now is how to abandon the manufacturing technology and process that the LED blue-light excites the yellow-light phosphor, so that the blue-light component in the lighting spectrum is minimal, thereby providing a sun-like spectrum LED lamp bead structure that can ensure the health and safety of human eyes, achieve the intelligent adjustment according to actual needs, arbitrarily simulate solar spectrum, and has a wide application range.

### SUMMARY

In order to solve the technical problems above, the present application provides a sun-like spectrum LED lamp bead structure, including a first polarity electrode, a plurality of LED chips and a circuit board;

wherein the first polarity electrode cooperates with the circuit board for encapsulating the plurality of LED chips;

the first polarity electrode has a three-dimensional structure including a plurality of planes;

each of the LED chips is respectively mounted on a corresponding plane; an electrode on a lighting plane of each of the LED chips is respectively connected to a corresponding soldering point on the circuit board; printed circuits, electrically connected to the soldering points, on the circuit board are respectively connected to corresponding voltage points on a divided second polarity electrode; and the other electrode of each of the LED chips is respectively connected to the first polarity electrode;

wherein the first polarity electrode and the second polarity electrode have opposite polarities;

the first polarity electrode has a design structure based on a semi-cylindrical surface, and has a plurality of planes thereon; a connecting line of a center point of each of the planes with a circle center of the semi-cylindrical surface of the design is respectively perpendicular to each of the corresponding planes; or,

the first polarity electrode has a design structure based on a hemispherical surface, and has a plurality of planes thereon;

two apex angles below the plurality of planes are connected to each other to form a regular polygon, a plane where the regular polygon is located is parallel to a plane of the hemispherical surface, and the two apex angles below each of the planes are both located on the hemispherical surface, two apex angles above the plurality of planes are both on a spherical surface of the plane of the hemispherical surface of the design intersecting with the hemispherical surface; connecting lines of center points of the plurality of planes with a sphere center of the hemispherical surface of the design are respectively perpendicular to each of the corresponding planes; or,

the first polarity electrode has an arbitrary-shaped three-dimensional structure including the plurality of planes; the arbitrarily-shaped three-dimensional structure is an arbitrarily structure that does not block light emitted by the LEDs on the planes from continuing to illuminate outwards after being focused and mixed at an intersection point thereof,, and is neither a semi-cylindrical surface design structure nor a hemispherical surface design structure; connecting lines of center points of the plurality of planes with the intersection point are respectively perpendicular to the corresponding planes.

Alternatively, a region of the first polarity electrode surrounding the lighting plane of the LED chip is provided with a polygonal flange plate;
a material of the first polarity electrode is metal;
the circuit board is arranged on the flange plate, and is connected to the flange plate through an adhesive.

Alternatively, the other end of the lighting plane of the LED chip of the first polarity electrode is provided with a cylindrical body;
the cylindrical body is sleeved with a heat sink, and thermally conductive adhesives are provided between the cylindrical body and the heat sink and between the flange plate and the heat sink.

Alternatively, the sun-like spectrum LED lamp bead structure further includes a plurality of soldering pieces; each of the soldering pieces is respectively mounted on one corresponding plane; each of the LED chips is respectively mounted on one corresponding soldering piece.

Alternatively, a central portion of each of the planes of the first polarity electrode is provided with an encapsulation groove for accommodating the soldering piece and the LED chip, and a depth of the encapsulation groove is greater than or equal to a thicknesses sum of the soldering piece and the LED chip, a size of the encapsulation groove is greater than a size of the LED chip and a size of the soldering piece;
when the first polarity electrode has the design structure based on a semi-cylindrical surface, a connecting line of a center point of a bottom plane of the encapsulation groove with a circle center of the semi-cylindrical surface of the first polarity electrode is perpendicular to the bottom plane of the encapsulation groove;
when the first polarity electrode has the design structure based on a hemispherical surface, a connecting line of the center point of the bottom plane of the encapsulation groove with a sphere center of the hemispherical surface is perpendicular to the bottom plane of the encapsulation groove;
when the first polarity electrode has the arbitrary-shaped three-dimensional design structure, a connecting line of the center point of the bottom plane of the encapsulation groove with the intersection point of the design structure is perpendicular to the bottom plane of the encapsulation groove;
wherein the soldering pieces and the LED chips are sequentially mounted in the encapsulation groove.

Alternatively, a central portion of each of the planes of the first polarity electrode is provided with an encapsulation blind hole for accommodating the soldering piece and the LED chip, and a depth of the encapsulation blind hole is smaller than or equal to a thicknesses sum of the soldering piece and the LED chip, a size of the encapsulation blind hole is greater than a size of the accommodated LED chip and a size of the accommodated soldering piece;
when the first polarity electrode has the design structure based on a semi-cylindrical surface, a connecting line of a center point of a bottom plane of the encapsulation blind hole with the circle center of the semi-cylindrical surface of the first polarity electrode is perpendicular to the bottom plane of the encapsulation blind hole;
when the first polarity electrode has the design structure based on a hemispherical surface, a connecting line of the center point of the bottom plane of the encapsulation blind hole with the sphere center of the hemispherical surface is perpendicular to the bottom plane of the encapsulation blind hole;
when the first polarity electrode has the arbitrary-shaped three-dimensional design structure, a connecting line of the center point of the bottom plane of the encapsulation blind hole with the intersection point of the design structure is perpendicular to the bottom plane of the encapsulation blind hole;
wherein the soldering piece and the LED chip are sequentially mounted in the encapsulation blind hole.

Alternatively, a shape of the soldering piece is the same as a shape of the corresponding LED chip;
a size of the soldering piece is smaller, or equal to, or greater than a size of the corresponding LED chip.

Alternatively, the circuit board is provided with a through hole having a stepped structure, or a notch having other predetermined shapes;
soldering points of different voltages on the second polarity electrode are located on a second stepped surface of the stepped structure of the circuit board;

Alternatively, the sun-like spectrum LED lamp bead structure further includes a multi-component adhesive;
the multi-component adhesive is configured to heat and solidify the connecting line of the LED chip with the first polarity electrode, the connecting line of the LED chip with the soldering point on the second stepped surface of the circuit board, and the soldering point;
Alternatively, the multi-component adhesive is filled to a horizontal position that does not exceed a first stepped surface of the circuit board.

Alternatively, light in multiple colors emitted by the plurality of LED chips is focused and mixed at an intersection point to generate a spectrogram of a sun-like spectrum LED lamp bead that can alleviate visual fatigue and prevent myopia; in the spectrogram, the minimum value of the main peak wave length is 535nm, the maximum value of the main peak wave length is 565nm, and the central value of the main peak wave length is 550nm; a wave band radiation flux of wave lengths 520nm-580nm is greater than 37% of that of wave lengths 380nm-780nm; a wave band radiation flux of wave lengths 380nm-480nm is smaller than 25% of that of wave lengths 380nm-780nm.

The sun-like spectrum LED lamp bead structure of the present application subverts the existing white-light LED manufacturing technology and process, abandons the technology that the white-light LED is manufactured by blue-light LED exciting yellow-light phosphor, and solves the problem that a lot of blue-light components cause health hazards to human body in the existing white-light LED manufacturing technology. Meanwhile, the present application achieves arbitrarily simulating solar spectrum so as to meet the needs of the growth and metabolism of creatures in the originally ecological light environment, and meets the vision of broad applications of ecological and intelligentized lighting in various fields in the future. The present application can maximize the energy-saving characteristics of LED semiconductors, achieve good color rendering properties and visual effects, and can be applied to various lighting fields, agriculture and animal husbandry fields, new energy fields where microorganisms are cultivated massively, backlight fields of electronic products and etc.

## BRIEF DESCRIPTION OF THE DRAWINGS

In order to more clearly describe the technical solutions of the present application or in the prior art, the drawings to be used in describing the embodiments or the prior art will be briefly described below. Obviously, the drawings in the following description are some embodiments of the present application; for those of ordinary skill in the art, other drawings may also be obtained based on these drawings without any creative work.

FIG.1 is an assembling diagram of the sun-like spectrum LED lamp bead structure according to an embodiment of the present application;

FIG.2 is a diagram of the LED structure in the sun-like spectrum LED lamp bead structure according to an embodiment of the present application;

FIG.3 is a diagram of the LED structure in the sun-like spectrum LED lamp bead structure according to another embodiment of the present application;

FIG.4 is a top view of the sun-like spectrum LED lamp bead structure according to an embodiment of the present application;

FIG.5 is a B-B section view of the sun-like spectrum LED lamp bead structure according to the embodiment shown in FIG.4 of the present application;

FIG.6 is a diagram of the sun-like LED spectrum suitable for the plants growth of the sun-like spectrum LED lamp bead structure according to the embodiment shown in FIG.4 of the present application;

FIG.7 is a top view of the sun-like spectrum LED lamp bead structure according to another embodiment of the present application;

FIG.8 is an A-A section view of the sun-like spectrum LED lamp bead structure according to the embodiment shown in FIG.7 of the present application;

FIG.9 is a spectrum diagram of the sun-like spectrum LED lamp bead structure that can alleviate visual fatigue and prevent myopia according to the embodiment shown in FIG.7 of the present application.

## DETAILED DESCRIPTION

In order to make the objectives, technical solutions, and advantages of the present application clearer, the technical solutions in the present application will be described clearly and fully with reference to the accompanying drawings hereinafter. Obviously, the described embodiments are merely some but not all of the embodiments of the present application. On the basis of the embodiments of the present application, all other embodiments obtained by the person of ordinary skill in the art without creative work shall fall within the protection scope of the present application.

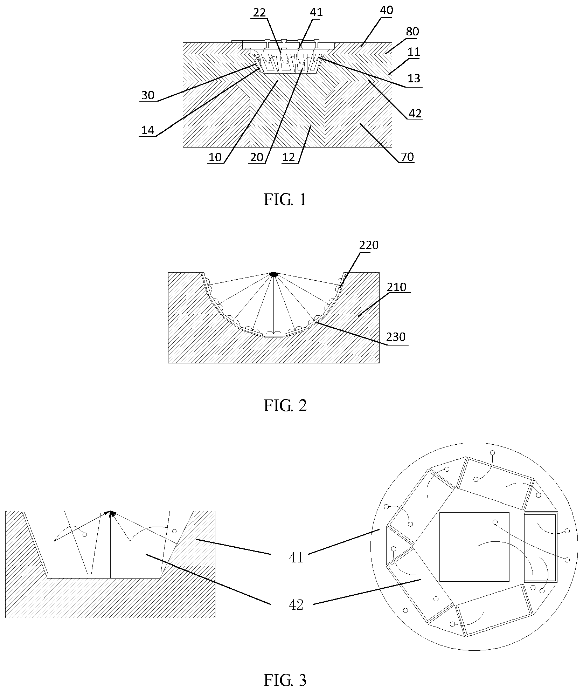

FIG.1 is an assembling diagram of the sun-like spectrum LED lamp bead structure according to an embodiment of the present application. As shown in FIG.1, the sun-like spectrum LED lamp bead structure includes a first polarity electrode 10 for three-dimensional integrated encapsulation, a plurality of LED chips 20 and a circuit board 40, wherein:

the first polarity electrode 10 cooperates with the circuit board 40 for encapsulating the plurality of LED chips 20;

the first polarity electrode 10 above has a three-dimensional structure including a plurality of planes, each of soldering pieces is respectively mounted on a corresponding plane, and each of the LED chips 20 is respectively mounted on a corresponding soldering piece 30; an electrode on a lighting plane of each of the LED chips is respectively connected to a corresponding soldering point 41 on the circuit board; printed circuits, electrically connected to the soldering points 41, on the circuit board 40 are respectively connected to corresponding voltage points on a divided second polarity electrode; the other electrode of each of the LED chips (on the lighting plane or the substrate) is connected to the first polarity electrode.

The first polarity electrode and the second polarity electrode have opposite polarities. Specifically, the first polarity electrode 10 may be a negative electrode for three-dimensional integrated encapsulation, and the second polarity electrode may be a positive electrode that have the opposite polarity; on the contrary, the second polarity electrode is a negative electrode when the first polarity electrode is a positive electrode for three-dimensional integrated encapsulation.

Preferably, the circuit board 40 may be a PCB (Printed Circuit Board) to be used as an electrical connection carrier for the sun-like spectrum LED lamp bead structure of the present embodiment.

By changing the current in each of the LED chips, the radiation flux of each of the LEDs can be changed, so as to control the proportion of each monochromatic light in the mixed light, thereby changing the spectrum of the mixed light. In this way, it is possible to respectively produce sun-like spectrum LED lamp beads having different band spectra, which are suitable for the living and metabolism of various organisms.

Wherein, as a preferred embodiment, the first polarity electrode 10 may be a structure based on a semi-cylindrical surface, and has a plurality of planes thereon; and a connecting line of a center point of each of the planes with a center of the semi-cylindrical surface is respectively perpendicular to each of the corresponding planes;

In addition, as the second preferred embodiment, the first polarity electrode 10 may be a structure based on a hemispherical surface, and has a plurality of planes thereon; two apex angles below the plurality of planes are connected to each other to form a regular polygon, a plane where the regular polygon is located is parallel to a plane of the hemispherical surface, and the two apex angles below each of the planes are both located on the hemispherical surface, two apex angles above the plurality of planes are both on a spherical surface of the plane of the hemispherical surface intersecting with the hemispherical surface; and connecting lines of center points of the plurality of planes with a sphere center of the hemispherical surface are respectively perpendicular to each of the corresponding planes;

In addition, as the third preferred embodiment, the first polarity electrode 10 may be an arbitrary-shaped three-dimensional structure including the plurality of planes; the arbitrarily-shaped three-dimensional structure is an arbitrarily structure that does not block light emitted by the LEDs on the planes from continuing to illuminate outwards after being focused and mixed at an intersection point, and is neither a semi-cylindrical surface structure nor a hemispherical surface structure; and connecting lines of center points of the plurality of planes with the intersection point are respectively perpendicular to the corresponding planes.

The sun-like spectrum LED lamp bead structure of the present application subverts the existing white-light LED manufacturing technology and process, abandons the prior art that the white-light LED is manufactured by blue-light LED exciting yellow-light phosphor, and solves the problem that a lot of blue-light components cause health hazards to human body in the existing white-light LED manufacturing technology. Meanwhile, the present application achieves arbitrarily simulating solar spectrum so as to meet the needs of the growth and metabolism of creatures in the originally ecological light environment, and meets the vision of broad applications of intelligentized lighting in various fields in the future. The sun-like spectrum LED lamp bead structure of the present application can achieve good color rendering properties and visual effects, and can be applied to various lighting fields, agriculture and animal husbandry fields, new energy fields where microorganisms are cultivated massively, backlight fields of electronic products and etc.

In addition, as shown in FIG.1, as a preference of the embodiments above, a region of the first polarity electrode 10 surrounding the lighting plane of the LED chip is provided with a polygonal flange plate 11;

the material of the first polarity electrode 10 is copper (or aluminum or Kovar material);

The PCB circuit board is arranged on the flange plate 11, and the circuit board is connected to a surface of the flange plate 11 through an adhesive 80.

Further, as a preference of each of the embodiments above, the sun-like spectrum LED lamp bead structure may also include a plurality of soldering pieces 30;

each of the soldering pieces is respectively mounted on one of the corresponding planes; each of the LED chips is respectively mounted on one of the corresponding soldering pieces.

Preferably, the material of the soldering piece is an environmentally friendly lead-free alloy material having a melting point of less than 300°C.

Further, as a preference of each of the embodiments above, the other end of the lighting plane of the LED chip of the first polarity electrode 10 is provided with a cylindrical body 12;

the cylindrical body 12 is sleeved with a heat sink 70, and thermally conductive adhesives 42 are provided between the cylindrical body 12 and the heat sink 70 and between the flange plate 11 and the heat sink 70.

It is to be appreciated that, when the power of the LED chip is small, the first polarity electrode 10 for three-dimensional integrated encapsulation may not be provided with the cylindrical body, and the heat sink is not required.

In addition, as a preference of each of the embodiments above, a central portion of each of the planes of the first polarity electrode 10 is provided with a encapsulation groove 14 for accommodating the soldering piece and the LED chip, and a depth of the encapsulation groove 14 is greater than or equal to a thicknesses sum of the soldering piece and the LED chip, a size of the encapsulation groove 14 is (slightly) greater than a size of the accommodated LED chip and a size of the accommodated soldering piece;

when the first polarity electrode is the structure based on a semi-cylindrical surface, a connecting line of a center point of a bottom plane of the encapsulation groove with a circle center of the semi-cylindrical surface of the first polarity electrode is perpendicular to the bottom plane of the encapsulation groove;

when the first polarity electrode is the structure based on a hemispherical surface, a connecting line of the center point of the bottom plane of the encapsulation groove with a sphere center of the hemispherical surface is perpendicular to the bottom plane of the encapsulation groove;

when the first polarity electrode is the arbitrary-shaped three-dimensional structure, a connecting line of the center point of the bottom plane of the encapsulation groove with the intersection point of the structure is perpendicular to the bottom plane of the encapsulation groove;

wherein the soldering pieces and the LED chips are sequentially mounted in the encapsulation groove. Each of the LED lighting planes faces the sphere center, the connecting lines of the center points of the lighting planes of each of the LED chips with the sphere center (the intersection point) of the hemispherical surface are respectively perpendicular to the corresponding LED lighting plane. And then it is heated to solder.

As an alternative embodiment of the encapsulation groove above, a central portion of each of the planes of the first polarity electrode may be provided with a encapsulation blind hole for accommodating the soldering piece and the LED chip, and a depth of the encapsulation blind hole is smaller than or equal to the thicknesses sum of the soldering piece and the LED chip, a size of the encapsulation blind hole is (slightly) greater than the size of the accommodated LED chip and the size of the accommodated soldering piece;

when the first polarity electrode is the structure based on a semi-cylindrical surface, a connecting line of a center point of a bottom plane of the encapsulation blind hole with the circle center of the semi-cylindrical surface of the first polarity electrode is perpendicular to the bottom plane of the encapsulation blind hole;

when the first polarity electrode is the structure based on a hemispherical surface, a connecting line of the center point of the bottom plane of the encapsulation blind hole with the sphere center of the hemispherical surface is perpendicular to the bottom plane of the encapsulation blind hole;

when the first polarity electrode is the arbitrary-shaped three-dimensional structure, a connecting line of the center point of the bottom plane of the encapsulation blind hole with the intersection point is perpendicular to the bottom plane of the encapsulation blind hole;

In addition, the LED chips are fixed by heating to solder.

It is to be appreciated that, in order to achieve a better soldering effect, a shape of the soldering piece is the same as that of the corresponding LED chip, and a size of the soldering piece is smaller than, or greater than, or equal to a size of the corresponding LED chip.

In addition, as shown in FIG.1, as a preference of the embodiments above, the circuit board may further be provided with a through hole having a stepped structure, or a notch having other predetermined shapes. Soldering points of different voltages on the second polarity electrode are located on a second stepped surface of the stepped structure of the circuit board.

In the embodiments above, the sun-like spectrum LED lamp bead structure further includes a multi-component adhesive for heating and solidifying the connecting line 13 of the LED chip with the first polarity electrode, the connecting line 22 of the LED chip with the soldering point of the circuit board, and the soldering point 41.

It should be noted that, the multi-component adhesive above is filled to a horizontal position that does not exceed a first stepped surface of the circuit board.

Compared with other existing heating and solidifying processes, the present embodiment can not only reduce the processing cost of the LED lamp bead, but also simplify the processing process.

Alternatively, the multi-component adhesive is, for example, an AB glue.

It is to be appreciated that, the plurality of LED chips correspond to different voltage parameters and different current parameters. After connecting the circuit and turning on the power, the light in different colors emitted by the LED chips having different wave lengths is focused and mixed at the sphere center of the hemispherical surface so as to form a tapered surface light source. The voltage and the passed current between two ends of each of the LED chips are obtained through experiments, therefore the needed parameters of the voltage and the passed current between two ends of each of the LED chips of various sun-like spectrum LEDs are obtained. The parameters are listed and set into the product manual of the sun-like spectrum LED lamp bead. The user lists and designs to provide the voltage and passed current parameters required for each LED chip according to the user manual, and thus various needed sun-like spectrum LED lamp bead products may be produced.

Specifically, FIG.2 is a diagram of the LED structure in the sun-like spectrum LED lamp bead structure according to an embodiment of the present application. As shown in FIG.2, the first polarity electrode (such as a negative electrode) 210 for three-dimensional integrated encapsulation is the structure based on a semi-cylindrical surface, and has a plurality of planes thereon. The connecting line of the center point of each of the planes with the circle center of the semi-cylindrical surface is respectively perpendicular to each of the corresponding planes. A plurality of soldering pieces 230 are respectively mounted on each of the corresponding planes and a plurality of LED chips 220 are respectively mounted on each of the corresponding soldering pieces. The lighting planes of the plurality of the LED chips face the circle center of the semi-cylindrical surface, the connecting lines of the center points of the lighting planes of each of the LED chips with the circle center of the semi-cylindrical surface are respectively perpendicular to a corresponding lighting plane, and intersects at the circle center of the semi-cylindrical surface. The light in different colors emitted by the plurality of the LED chips is focused and mixed at the circle center of the semi-cylindrical surface electrode to form a sector-shaped surface light source.

It is to be appreciated that, the plurality of LED chips correspond to different voltage parameters and different current parameters. After connecting the circuit and turning on the power, the light in different colors emitted by the LED chips having different wave lengths is focused and mixed at the circle center of the semi-cylindrical surface so as to form a sector-shaped surface light source. By providing different voltages and passed currents to the plurality of the LED chips, the proportions of various lights in the mixed light can be changed and the needed sun-like LED spectrum is obtained.

In addition, as another alternative embodiment, the first polarity electrode may also be a structure based on a hemispherical surface, and has a plurality of planes thereon. Two apex angles below the plurality of planes are connected to each other to form a regular polygon, the plane where the regular polygon is located is parallel to the plane of the hemispherical surface, and the two apex angles below each of the planes are both located on the hemispherical surface, two apex angles above the plurality of planes are both on the spherical surface of the plane of the hemispherical surface intersecting with the hemispherical surface.

The connecting lines of the center points of the plurality of planes with the sphere center of the hemispherical surface are respectively perpendicular to each of the corresponding planes.

Specifically, FIG.3 is a diagram of the LED structure in the sun-like spectrum LED lamp bead structure according to another embodiment of the present application. As shown in FIG.3, the LED structure of the present embodiment includes a negative electrode 41 for three-dimensional integrated encapsulation which is a structure based on a hemispherical surface, a plurality of LED chips 42 having different wave lengths (as shown in FIG.3, there are 6 LED chips including an LED chip provided at the central portion of the bottom of the electrode).

The negative electrode 41 for three-dimensional integrated encapsulation is a structure based on a hemispherical surface, and has a plurality of planes thereon. Two apex angles below the plurality of planes are connected to each other to form a regular polygon, the plane of the regular polygon is parallel to the plane of the hemispherical surface, and the two apex angles below the regular polygon are both designed on the hemispherical surface; two apex angles above the plurality of planes are both designed on a hemispherical surface of the plane of the hemispherical surface intersecting with the hemispherical surface. Connecting lines of the center point of each of the planes with the sphere center of the hemispherical surface are respectively perpendicular to each of the corresponding planes. The soldering pieces and the plurality of LED chips are sequentially mounted each of the planes, respectively, wherein each of the planes is mounted with a soldering piece and an LED chip; the lighting planes of the plurality of LED chips face the sphere center of the hemispherical surface. The light in different colors emitted by the plurality of LED chips is focused and mixed at the sphere center of the hemispherical surface to form a tapered surface light source.

Similarly, the plurality of LED chips of the present embodiment correspond to different voltage parameters and different current parameters. After connecting the circuit and turning on the power, the light in different colors emitted by the LED chips having different wave lengths is focused and mixed at the sphere center of the hemispherical surface so as to form a tapered surface light source. By providing different voltages and passed currents to the plurality of LED chips, the proportions of various lights in the mixed light can be changed and the needed sun-like LED spectrum is obtained.

In addition, as another preferred embodiment, the first polarity electrode may also be an arbitrary-shaped three-dimensional structure including the plurality of planes. The connecting lines of the center points of the plurality of planes with the intersection point are respectively perpendicular to the corresponding planes.

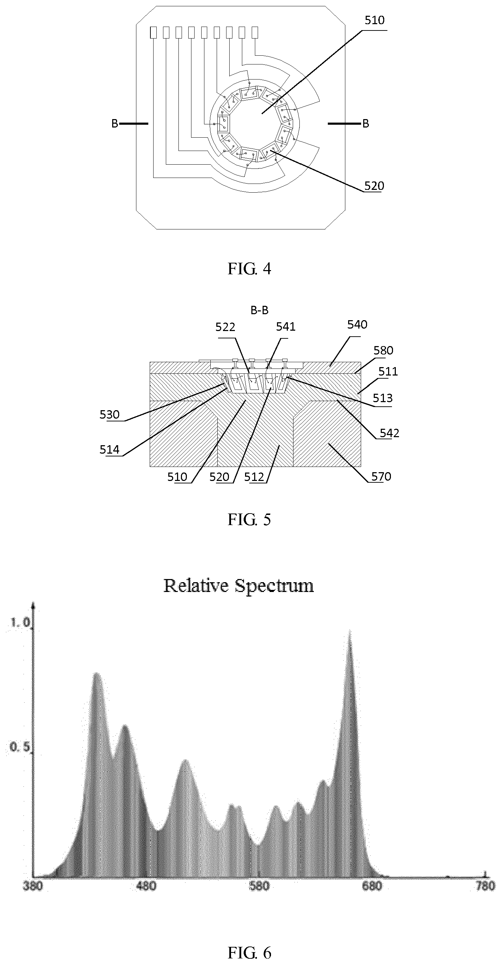

In addition, FIG.4 is a top view of the sun-like spectrum LED lamp bead structure according to another embodiment of the present application; FIG.5 is a B-B section view of the sun-like spectrum LED lamp bead structure according to the embodiment shown in FIG.4. As shown in FIG.4 and FIG.5, the sun-like spectrum LED lamp bead structure of the present embodiment includes a first polarity electrode (such as a positive electrode) 510 for three-dimensional integrated encapsulation, a plurality of LED chips 520, a PCB board 540 of a stepped structure for three-dimensional integrated encapsulation, and a plurality of soldering pieces 530 and heat sinks 570 corresponding to each of the LED chips.

In order to provide a sun-like LED spectrum suitable for the plants growth, the positive electrode 510 for three-dimensional integrated encapsulation is designed to be a structure based on a hemispherical surface, and adopts 9 LED chips having different wave lengths.

Specifically, the positive electrode 510 for three-dimensional integrated encapsulation is designed to be a structure based on a hemispherical surface, and 9 planes are machined thereon. The connecting line of the center point of each of the planes with the sphere center of the hemispherical surface is respectively perpendicular to the corresponding planes. Rectangular grooves 514 for mounting the soldering piece and the LED chip are respectively machined with the center points of the plurality of planes as the center. The depth of the rectangular groove 514 is slightly smaller than the depth sum of the soldering piece 530 and the LED chip 520, and the size of the rectangular groove is (slightly) greater than the sizes of the accommodated soldering piece and LED chip.

The plurality of soldering pieces 530 are respectively mounted in the rectangular grooves 514 on each of the corresponding planes, the plurality of LED chips 520 are respectively mounted on each of the corresponding soldering pieces, and the lighting planes of the plurality of LED chips 520 face the sphere center of the hemispherical surface. The LED chips 520 are connected to the positive electrode 510 by heating to solder.

Wherein the connecting lines of the center points of the lighting planes of the plurality of LED chips 520 with the sphere center of the hemispherical surface are respectively perpendicular to each of the corresponding LED lighting planes, and are focused and mixed at the sphere center of the hemispherical surface; the material of the positive electrode 510 having the first polarity is copper (steel or aluminum); and the PCB board 540 having the steeped structure is bonded to the flange plate 511 of the positive electrode 510 for three-dimensional integrated encapsulation through adhesive 580.

It should be noted that the PCB board above has a design principle that the light emitted by the 9 LED chips 520 is not blocked from continuing to illuminate outwards after being focused and mixed at the intersection point.

A plurality of soldering points 541 having the negative polarity of different voltages on a second stepped surface of the PCB board are respectively connected to the corresponding negative poles on the lighting planes of the LED chips 520. The printed circuit on the PCB board connected to the soldering points are respectively connected to corresponding voltage points on the voltage dividing negative electrode, and the positive poles of the plurality of LED chips 520 (on the lighting plane or on the substrate) are connected to the positive electrode 510.

The heat sinks 570 may be sleeved on a cylindrical body 512 of the positive electrode 510.

As a preference of the present embodiment, thermally conductive adhesive 542 may be used between the heat sink 570 and the flange plate 511 as well as between the heat sink 570 and the cylindrical body 512, for adhesion.

For example, the wave lengths, powers and sizes of the 9 LED chips with different specifications of the present embodiment, and the corresponding sizes of the soldering pieces and sizes of the encapsulation rectangular grooves machined on the positive electrode 510 are shown in the following table I.

Table I Design Parameters of the Sun-like Spectrum LED Lamp Bead Structure Suitable for the Growth of Plants

| LED | LED11 | LED12 | LED13 | LED14 | LED15 | LED16 | LED17 | LED18 | LED19 |
|---|---|---|---|---|---|---|---|---|---|
| Wavelength (nm) | 661 | 636 | 614 | 558 | 565 | 596 | 437 | 461 | 518 |
| Power (W) | 0.5 | 0.2 | 0.2 | 0.5 | 0.2 | 0.2 | 0.5 | 0.2 | 0.2 |
| Size (mm) | 0.931*0.931 | 0.3675*0.735 | 0.49*0.49 | 0.931*0.931 | 0.49*0.49 | 0.49*0.49 | 0.931*0.931 | 0.3675*0.735 | 0.49*0.49 |
| Soldering piece size (mm) | 0.93*0.93 | 0.367*0.735 | 0.49*0.49 | 0.93*0.93 | 0.49*0.49 | 0.49*0.49 | 0.93*0.93 | 0.367*0.735 | 0.49*0.49 |
| | HL11 | HL12 | HL13 | HL14 | HL15 | HL16 | HL17 | HL18 | HL19 |
| Groove number | 1 | 2 | 3 | 4 | 5 | 6 | 7 | 8 | 9 |
| Groove size (mm) | 0.937*0.937 | 0.372*0.740 | 0.495*0.495 | 0.937*0.937 | 0.495*0.495 | 0.495*0.495 | 0.937*0.937 | 0.372*0.740 | 0.495*0.495 |

As shown in FIG.4 and FIG.5, the positive electrode 510 of the present embodiment is designed on the basis of a hemispherical surface, the bottom thereof is not provided with chips, therefore n=9.

The sizes of the 9 chips are smaller than $(1\times1)$ mm$^2$, therefore the 9 encapsulation planes are designed according to L+M=1mm (wherein L is a side size of the LED chip, M is an interval between two adjacent LED chips). In addition, according to the different size of each of the LED chips, the corresponding encapsulation rectangular grooves are respectively machined with the center points of the corresponding 9 encapsulation planes as the centers, and according to the following Equation (1), the sphere radius can be calculated as equal to 1.7457mm, the distance from the center point of the encapsulation plane to the regular nonagon plane at the bottom is 0.4771mm, the angles of the 9 encapsulation planes with the regular nonagon plane at the bottom are 107.3916 degree. Wherein the sphere radius equation on the design basis of the hemispherical surface is as follows:

$$\text{Ra} = \frac{1}{2}(L+M)\sqrt{\frac{1}{4}\left[\tan\frac{90°(n-2)}{n}+\sqrt{\left(\tan\frac{90°(n-2)}{n}\right)^2+8}\right]^2+1} \quad (1)$$

Wherein Ra is the sphere radius on the design basis of the hemispherical surface; L is the side size of the LED chip; M is the interval between two adjacent LED chips; n is the number of the LED chips (n≥3).

9 encapsulation rectangular grooves 514 for mounting the soldering piece and the LED chip are respectively machined on each of the planes of the positive electrode 510 with the center point as the center according to different chip sizes. The depths of the 9 encapsulation rectangular groove are slightly smaller than the thickness sum of the soldering piece and the LED chip, and the length and width sizes of the 9 encapsulation rectangular grooves are respectively (slightly) greater than the sizes of the accommodated LED chip and soldering piece.

Meanwhile, the positive electrode 510 for three-dimensional integrated encapsulation is further provided with a flange plate (a square flange plate is preferred) 511 for encapsulation, positioning and heat dissipation, and a cylindrical body 512 for connecting the heat sink. The material of the positive electrode 510 for three-dimensional integrated encapsulation is copper (or steel or aluminum).

The soldering pieces HL11-HL19 are respectively mounted in the corresponding encapsulation rectangular grooves on the positive electrodes 510 according to the sizes thereof. The 9 soldering pieces are mounted with 9 LED chips 520 matching the shapes thereof correspondingly, and the lighting plane of each of the LED chips faces the sphere center of the hemispherical surface. The connecting lines of the center points of the lighting planes of the 9 LED chips with the sphere center (intersection point) of the hemispherical surface are respectively perpendicular to the corresponding LED lighting planes, so as to be processed by heating to solder.

Similar to the embodiment shown in FIG.1, the PCB board of the present embodiment is also encapsulated on the square flange plate, and has through holes with stepped structure, wherein the shape and position of the through hole are designed under a principle that the light emitted by the 9 LED chips is not blocked from continuing to illuminate outwards after being focused and mixed at the intersection point.

The PCB board 540 is arranged on the flange plate 511, and the PCB board 540 is connected to the surface of the flange plate 511 through the adhesive 580.

A plurality of soldering points 541 having the negative polarity of different voltages on the second stepped surface of the PCB board are respectively connected to the negative poles on the lighting planes of the corresponding LED chip 520. The printed circuits on the PCB board connected to the soldering points are respectively connected to corresponding voltage points on the voltage dividing negative electrode.

The positive poles of the 9 LED chips 520 (on the lighting plane or on the substrate) are connected to the positive electrode 510.

Preferably, the heat sink 570 is sleeved on the cylindrical body 512 of the positive electrode 510, and thermally conductive adhesive 542 are used between the heat sink 570 and the flange plate 511 as well as between the heat sink 570 and the cylindrical body 512, for adhesion.

In addition, the connecting lines 513 of the positive poles of the LED chips with the positive electrode for three-dimensional integrated encapsulation, the connecting lines 522 of the negative poles of the LED chips with the soldering points on the second stepped of the PCB board, and the soldering points 541 are fixed by pouring AB glue , wherein the AB glue may be arranged to fill until the horizontal position of the first stepped of the PCB board 540 for heating and solidification.

In addition, after connecting the circuit and turning on the power, the light of 9 different colors emitted by the LED chips LED11-LED19 having 9 different wave lengths is focused and mixed at the sphere center of the hemispherical surface to form a tapered surface light source.

In addition, by providing different voltages and passed currents to the 9 LED chips respectively, the proportion of the light of 9 different colors in the mixed light can be changed so as to obtain the sun-like LED spectrum suitable for the growth of plants.

The parameters of the voltages and passed currents at two ends of the 9 LED chips of the sun-like LED spectrum, which are obtained through experiments and suitable for the plants growth, are listed and set into the product manual of the sun-like spectrum LED lamp bead.

Specifically, FIG.6 is a sun-like LED spectrum diagram suitable for the plants growth of the sun-like spectrum LED lamp bead structure according to the embodiment shown in FIG.4 of the present application. Wherein, the present embodiment uses FMS-6000 light-color-electric comprehensive test system to conduct the spectrum test. It can be seen from FIG.6 that the present embodiment can perfectly manufacture the sun-like spectrum LED lamp bead suitable for the growth of plants.

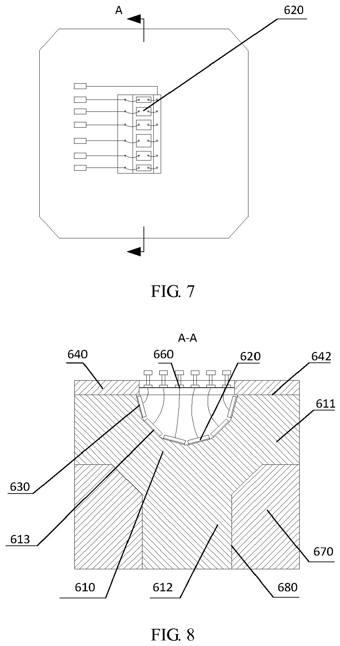

In addition, FIG.7 is a top view of the sun-like spectrum LED lamp bead structure according to another embodiment of the present application; FIG.8 is an A-A section view of the sun-like spectrum LED lamp bead structure according to the embodiment shown in FIG.7. As shown in FIG.7 and FIG.8, the sun-like spectrum LED lamp bead structure of the present embodiment includes a negative electrode 610 for three-dimensional integrated encapsulation, 6 LED chips 620, a PCB board 640 of a stepped structure for three-dimensional integrated encapsulation and heat sinks 670.

In order to provide a sun-like LED spectrum that can alleviate visual fatigue and prevent myopia, the first polarity electrode (such as negative electrode) for three-dimensional integrated encapsulation of the sun-like spectrum LED lamp bead structure of the present embodiment is designed to be a structure based on a semi-cylindrical surface, and adopts 6 LED chips having different wave lengths.

For example, the wave lengths, powers and sizes of the 6 LED chips with different specifications of the present embodiment, and the coating size of the corresponding solder paste (or conductive adhesive) 630, and the sizes of the encapsulation rectangular grooves 613 machined on the negative electrode 610 are shown in the following table II.

Table II Design Parameters of the Sun-like Spectrum LED Lamp Bead Structure for alleviating visual fatigue and preventing myopia

| LED | LED21 | LED22 | LED23 | LED24 | LED25 | LED26 |
|---|---|---|---|---|---|---|
| Wave length (nm) | 458 | 510 | 552 | 586 | 604 | 627 |
| Power (W) | 0.5 | 0.2 | 0.5 | 0.2 | 0.5 | 0.2 |
| Size (mm) | 0.931*0.931 | 0.49*0.49 | 0.931*0.931 | 0.49*0.49 | 0.931*0.931 | 0.3675*0.735 |
| Solder paste (or conductive adhesive)-coated groove number | 1 | 2 | 3 | 4 | 5 | 6 |
| Solder paste (or conductive adhesive) coating size (mm) | 0.931*0.931 | 0.49*0.49 | 0.931*0.931 | 0.49*.049 | 0.931*0.931 | 0.367*0.73 |
| Encapsulation groove number | 1 | 2 | 3 | 4 | 5 | 6 |
| Encapsulation groove size (mm) | 0.937*0.937 | 0.495*0.495 | 0.937*0.937 | 0.495*0.495 | 0.937*0.937 | 0.372*0.740 |

The sizes of the 6 chips are smaller than $(1\times1)$ mm$^2$, therefore the 6 encapsulation planes are based on L+M=1mm, the negative electrode 610 is designed to be a structure based on a semi-cylindrical surface, and the design radius of the semi-cylindrical surface is 1.932mm, calculated according to the following Equation (2). Wherein the cylindrical radius equation on the design basis of the semi-cylindrical surface is as follows:

$$\text{Ra} = \frac{1}{2}(L+M)/\sin\frac{90°}{n} \quad (2)$$

Wherein Ra is the cylindrical radius on the design basis of the semi-cylindrical surface; L is the side size of the LED chip; M is the interval between two adjacent LED chips; n is the number of the LED chips.

In addition, the negative electrode 610 of the present embodiment may be designed to include 6 planes, and to be provided with 6 encapsulation rectangular grooves 613 with the center points of the 6 planes as the centers.

Preferably, the depth of the encapsulation rectangular groove 613 is slightly smaller than the thickness sum of the solder paste (or conductive adhesive) 630 and the LED chip, and the length and width sizes of the encapsulation rectangular grooves are (slightly) greater than the size of the accommodated LED chip and the coating size of the solder paste (or conductive adhesive). The connecting lines of the center points of the bottom planes of the 6 encapsulation rectangular grooves with the circle center of the semi-cylindrical surface are respectively perpendicular to the corresponding bottom planes of the encapsulation rectangular grooves.

Meanwhile, the negative electrode 610 for three-dimensional integrated encapsulation is further provided with a flange plate (a square flange plate is preferred) 611 for encapsulation, positioning and heat dissipation, and a cylindrical body 612 for connecting to the heat sink.

The material of the first polarity negative electrode 610 is metal copper (or PCB or ceramic or carborundum).

Preferably, when the power of the LED chip is small, the negative electrode 610 for three-dimensional integrated encapsulation may not be provided with the cylindrical body, and the heat sink is not required.

In addition, the solder paste (or conductive adhesive) 630 is coated in the corresponding 6 encapsulation rectangular grooves 613 on the negative electrode according to the designed size and thickness. The 6 encapsulation rectangular grooves 613 coated with the solder paste (or conductive adhesive) 630 are provided with 6 LED chips 620 matching the shapes thereof. The lighting planes of the 6 LED chips face the center of the semi-cylindrical surface, and the connecting lines of the center points of the lighting planes of the 6 LED chips with the circle center (intersection point) of the semi-cylindrical surface are respectively perpendicular to the corresponding LED lighting planes, so as to be machined by heating to solder.

Similar to the embodiment shown in FIG.1, the PCB board 640 having the stepped structure is bonded to the flange plate 611 of the negative electrode 610 for three-dimensional integrated encapsulation through adhesive 642.

The PCB board 640 has rectangular through holes having a stepped structure, and the shape and position of the through hole has a design principle that the light emitted by the LED chips 620 is not blocked from continuing to illuminate outwards after being focused and mixed at the intersection point.

A plurality of soldering points 660 having positive polarity of different voltages on the second stepped surface of the PCB board are respectively connected to the corresponding positive poles on the lighting planes of the LED chips 620. The printed circuits on the PCB board connected to the soldering points are respectively connected to corresponding voltage points on the voltage dividing positive electrode.

And the negative electrodes of the 6 LED chips 620 (on the lighting plane or on the substrate) are connected to the negative electrode 610 for three-dimensional integrated encapsulation.

Preferably, the heat sink 670 is sleeved on the cylindrical body 612 of the negative electrode 610 for three-dimensional encapsulation, and thermally conductive adhesive 680 are used between the heat sink 670 and the flange plate 611 as well as between the heat sink 670 and the cylindrical body 612, for adhesion.

In addition, the connecting lines of the LED chips with the negative electrode for three-dimensional integrated encapsulation, the connecting lines of the LED chips with the soldering points on the second stepped of the PCB board, and the soldering points are fixed by pouring AB glue, wherein the AB glue may be arranged to fill until the horizontal position of the first stepped of the PCB board for heating and solidification.

In addition, after connecting the circuit and turning on the power, the light of 6 different colors emitted by the LED chips LED21-LED26 having 6 different wave lengths is focused and mixed at the circle center of the semi-cylindrical surface to form a fan-shaped surface light source.

By providing different voltages and passed currents to the 6 LED chips respectively, the proportion of the light in 6 different colors in the mixed light can be changed so as to obtain the sun-like LED spectrum that can alleviate visual fatigue and prevent myopia.

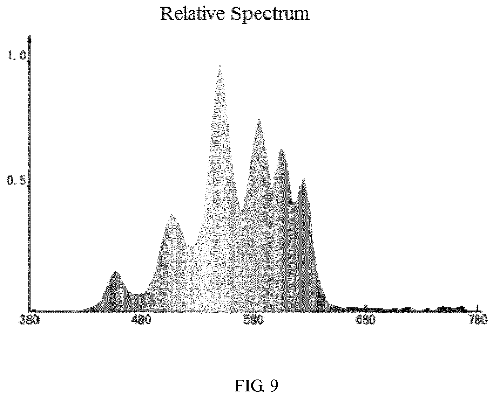

Specifically, FIG.9 is a spectrum diagram of the sun-like spectrum LED lamp bead structure that can alleviate visual fatigue and prevent myopia according to the embodiment shown in FIG.7 of the present application. Wherein, the present embodiment uses FMS-6000 light-color-electric comprehensive test system to conduct the spectrum test.

It can be seen from FIG.9 that, the spectrum of the sun-like spectrum LED lamp bead structure of the present embodiment has a main peak wave length minimum value of 535nm, a main peak wave length maximum value of 565nm, a main peak wave length central value of 550nm; a wave band radiation flux of wave lengths 520nm-580nm is greater than 37% of that of wave lengths 380nm-780nm; a wave band radiation flux of wave lengths 380nm-480nm is smaller than 25% of that of wave lengths 380nm-780nm. Therefore, the present embodiment can manufacture a sun-like spectrum LED lamp bead that can alleviate visual fatigue and prevent myopia.

It should be noted that, in the description of the present application, the orientation or position relations indicated by the terms "circle center", "sphere center", "center", "upper", "lower", "semi-cylindrical surface", "hemispherical surface", "interval", "first stepped", "second stepped", "groove", "blind hole", "conduct", "connect", "bond", "fix", "first polarity", "second polarity", etc. are based on the orientation and position relations shown in the drawings, which is merely for the convenience of describing the present application and simplifying the description, and is not to indicate or imply that the referred device or component must have a specific shape, a structure having the specific shape and a specific operation. Therefore it cannot be construed as limiting the present application. A "plane" may be a square plane, a rectangular plane, or a plane of other shapes, depending on the shape of the selected chip. Unless specifically defined and described otherwise, the terms "mount" "encapsulate", "connect", "turn on", "conduct", "machine" and "manufacture" are to be construed broadly. For example, a connection may be a mechanical connection or an electrical connection; it may be a direct connection or an indirect connection via an intermediate medium, or it may be an internal connection of two components. For a person of ordinary skill in the art, the specific meanings of the terms above in the present application can be understood according to specific situations. In the description of the present application, unless specified otherwise, "a plurality of' means two or more.

The apparatus embodiments described above are only illustrative, in which the modules described as separate parts may be or may not be physically separated, and the parts displayed as modules may be or may not be physical modules, that is, they may be located in one place, or may also be distributed to multiple network modules. According to actual needs, some or all of the modules may be selected to achieve the objects of the solutions of the embodiments. Those of ordinary skill in the art can understand and implement without creative work.

Through the description of the embodiments above, those skilled in the art can clearly understand that each embodiment can be implemented by means of software with necessary universal hardware platform, and can also, of course, by means of hardware. Based on such understanding, the technical solutions of the present application, or the part thereof contributing to the prior art can be embodied in the form of a software product stored in a computer-readable storage medium, such as ROM/RAM, magnetic disk, optical disk, etc. The software product includes certain instructions so that a computer device (may be a personal computer, a server, or a network device, etc.) performs each of the embodiments, or some parts of the embodiments.

Finally, it should be noted that the embodiments above are only used to illustrate rather than to limit the technical solutions of the present application; although the present application has been described in detail with reference to the foregoing embodiments, those of ordinary skills in the art should understand that they can still modify the technical solutions described in the foregoing embodiments, or equivalently replace some of the technical features therein; and these modifications or replacements do not separate the essence of the corresponding technical solutions from the spirit and scope of each of the embodiments of the present application.

## Claims

1. A sun-like spectrum LED lamp bead structure, **characterized in** comprising a first polarity electrode, a plurality of LED chips and a circuit board; wherein
the first polarity electrode cooperates with the circuit board for encapsulating the plurality of LED chips;
the first polarity electrode is a three-dimensional structure comprising a plurality of planes;
each of the LED chips is respectively mounted on a corresponding plane; an electrode on a lighting plane of each of the LED chips is respectively connected to a corresponding soldering point on the circuit board; printed circuits, connected to the soldering points, on the circuit board are respectively connected to corresponding voltage points on a divided second polarity electrode; the other electrode of each of the LED chips is connected to the first polarity electrode;
wherein the first polarity electrode and the second polarity electrode have opposite polarities;
the first polarity electrode is a structure based on a semi-cylindrical surface, and has a plurality of planes thereon; a connecting line of a center point of each of the planes with a circle center of the semi-cylindrical surface is respectively perpendicular to each of the corresponding planes; or,
the first polarity electrode is a structure based on a hemispherical surface, and has a plurality of planes thereon; two apex angles below the plurality of planes are connected to each other to form a regular polygon, a plane where the regular polygon is located is parallel to a plane of the hemispherical surface, and the two apex angles below each of the planes are located on the hemispherical surface, two apex angles above the plurality of planes are on a spherical surface of the plane of the hemispherical surface intersecting with the hemispherical surface; connecting lines of center points of the plurality of planes with a sphere center of the hemispherical surface are respectively perpendicular to each of the corresponding planes; or,
the first polarity electrode is an arbitrary-shaped three-dimensional structure comprising the plurality of planes; the arbitrarily-shaped three-dimensional structure is an arbitrarily structure that does not block light emitted by the LEDs on the planes from continuing to illuminate outwards after being focused and mixed at an intersection point, and is neither a semi-cylindrical surface structure nor a hemispherical surface structure; connecting lines of center points of the plurality of planes with the intersection point are respectively perpendicular to the corresponding planes.

2. The sun-like spectrum LED lamp bead structure of claim 1, **characterized in that** a region of the first polarity electrode surrounding the lighting plane of the LED chip is provided with a polygonal flange plate;
a material of the first polarity electrode is metal;
the circuit board is arranged on the flange plate, and is connected to the flange plate through an adhesive.

3. The sun-like spectrum LED lamp bead structure of claim 1, **characterized in that** the other end of the lighting plane of the LED chip of the first polarity electrode is provided with a cylindrical body;

the cylindrical body is sleeved with a heat sink, and thermally conductive adhesives are provided between the cylindrical body and the heat sink and between the flange plate and the heat sink.

4. The sun-like spectrum LED lamp bead structure of claim 1, **characterized in that** it further comprises a plurality of soldering pieces;

each of the soldering pieces is respectively mounted on one of the corresponding planes; each of the LED chips is respectively mounted on one of the corresponding soldering pieces.

5. The sun-like spectrum LED lamp bead structure of claim 4, **characterized in that** a central portion of each of the planes of the first polarity electrode is provided with a encapsulation groove for accommodating the soldering piece and the LED chip, and a depth of the encapsulation groove is greater than or equal to a thicknesses sum of the soldering piece and the LED chip, a size of the encapsulation groove is greater than a size of the LED chip and a size of the soldering piece;

when the first polarity electrode is the structure based on a semi-cylindrical surface, a connecting line of a center point of a bottom plane of the encapsulation groove with a circle center of the semi-cylindrical surface of the first polarity electrode is perpendicular to the bottom plane of the encapsulation groove;

when the first polarity electrode is the structure based on a hemispherical surface, a connecting line of the center point of the bottom plane of the encapsulation groove with a sphere center of the hemispherical surface is perpendicular to the bottom plane of the encapsulation groove;

when the first polarity electrode is the arbitrary-shaped three-dimensional structure, a connecting line of the center point of the bottom plane of the encapsulation groove with the intersection point is perpendicular to the bottom plane of the encapsulation groove;

wherein the soldering pieces and the LED chips are sequentially mounted in the encapsulation groove.

6. The sun-like spectrum LED lamp bead structure of claim 4, **characterized in that** a central portion of each of the planes of the first polarity electrode is provided with an encapsulation blind hole for accommodating the soldering piece and the LED chip, and a depth of the encapsulation blind hole is smaller than or equal to a thicknesses sum of the soldering piece and the LED chip, a size of the encapsulation blind hole is greater than a size of the accommodated LED chip and a size of the accommodated soldering piece;

when the first polarity electrode is the structure based on a semi-cylindrical surface, a connecting line of a center point of a bottom plane of the encapsulation blind hole with the circle center of the semi-cylindrical surface of the first polarity electrode is perpendicular to the bottom plane of the encapsulation blind hole;

when the first polarity electrode is the structure based on a hemispherical surface, a connecting line of the center point of the bottom plane of the encapsulation blind hole with the sphere center of the hemispherical surface is perpendicular to the bottom plane of the encapsulation blind hole;

when the first polarity electrode is the arbitrary-shaped three-dimensional structure, a connecting line of the center point of the bottom plane of the encapsulation blind hole with the intersection point is perpendicular to the bottom plane of the encapsulation blind hole;

wherein the soldering piece and the LED chip are sequentially mounted in the encapsulation blind hole.

7. The sun-like spectrum LED lamp bead structure of claim 4, **characterized in that** a shape of the soldering piece is the same as a shape of the corresponding LED chip;

a size of the soldering piece is smaller, or equal to, or greater than a size of the corresponding LED chip.

8. The sun-like spectrum LED lamp bead structure of claim 1, **characterized in that** the circuit board is provided with a through hole having a stepped structure, or a notch having other predetermined shapes;

soldering points of different voltages on the second polarity electrode are located on a second stepped surface of the stepped structure of the circuit board;

9. The sun-like spectrum LED lamp bead structure of claim 8, **characterized in that** it further comprises a multi-component adhesive;

the multi-component adhesive is configured to heat and solidify the connecting line of the LED chip with the first polarity electrode, the connecting line of the LED chip with the soldering point on the second stepped surface of the circuit board, and the soldering point;

the multi-component adhesive is filled to a horizontal position that does not exceed a first stepped of the circuit board.

10. The sun-like spectrum LED lamp bead structure of claim 1, **characterized in that** light in multiple colors emitted by the plurality of LED chips is focused and mixed at an intersection point to generate a spectrogram of a sun-like spectrum LED lamp bead that can alleviate visual fatigue and prevent myopia; in the spectrogram, a main peak wave length minimum value is 535nm, a main peak wave length maximum value is 565nm, and a main peak wave length central value is 550nm; a wave band radiation flux of wave lengths 520nm-580nm is greater than 37% of that of wave lengths 380nm-780nm; a wave band radiation flux of wave lengths 380nm-480nm is smaller than 25% of that of wave lengths 380nm-780nm.

FIG. 1

FIG. 2

FIG. 3

FIG. 4

FIG. 5

FIG. 6

A

620

FIG. 7

A-A

640    660    620    642

611

630

613

670

610    612    680

FIG. 8

FIG. 9

# INTERNATIONAL SEARCH REPORT

| International application No. |
|---|
| PCT/CN2016/099797 |

## A. CLASSIFICATION OF SUBJECT MATTER

H01L 33/48 (2010.01) i; H01L 33/62 (2010.01) i; F21S 2/00 (2016.01) i

According to International Patent Classification (IPC) or to both national classification and IPC

## B. FIELDS SEARCHED

Minimum documentation searched (classification system followed by classification symbols)

H01L 33/-, F21S

Documentation searched other than minimum documentation to the extent that such documents are included in the fields searched

Electronic data base consulted during the international search (name of data base and, where practicable, search terms used)

CNPAT, CNKI, EPODOC, WPI: 发光二极管, LED, 灯珠, 封装, 太阳, 光谱, 日光, 阳光, 立体, 圆台, 球, 圆柱, 圆锥, LED, hemisphere, bead, column, cylinder, package, ball, solar, sun, light

## C. DOCUMENTS CONSIDERED TO BE RELEVANT

| Category* | Citation of document, with indication, where appropriate, of the relevant passages | Relevant to claim No. |
|---|---|---|
| A | CN 101764067 A (XIAMEN UNIVERSITY) 30 June 2010 (30.06.2010), description, paragraphs [0002]-[0025], and figures 4-6 | 1-10 |
| A | CN 1710725 A (ZHANG, Yu) 21 December 2005 (21.12.2005), entire document | 1-10 |
| A | CN 202205741 U (DUJIANGYAN HUAGANG ELECTRONIC TECHNOLOGY CO., LTD.) 25 April 2012 (25.04.2012), entire document | 1-10 |
| A | JP 2004211621 A (ESHIKKU K. K.) 04 November 2004 (04.11.2004), entire document | 1-10 |
| A | US 5838247 A (BLADOWSKI, WITOKD S.) 17 November 1998 (17.11.1998), entire document | 1-10 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 April 2017 | 31 May 2017 |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>CHEN, Jiajia<br><br>Telephone No. (86-10) 61648430 |

Form PCT/ISA/210 (second sheet) (July 2009)

**INTERNATIONAL SEARCH REPORT**
Information on patent family members

| | International application No. |
|---|---|
| | PCT/CN2016/099797 |

| Patent Documents referred in the Report | Publication Date | Patent Family | Publication Date |
|---|---|---|---|
| CN 101764067 A | 30 June 2010 | None | |
| CN 1710725 A | 21 December 2005 | CN 100356597 C | 19 December 2007 |
| CN 202205741 U | 25 April 2012 | None | |
| JP 2004211621 A | 04 November 2004 | None | |
| US 5838247 A | 17 November 1998 | CA 2214057 A1 | 01 October 1998 |

Form PCT/ISA /210 (patent family annex) (July 2009)